Europäisches Patentamt

European Patent Office

Office européen des brevets

(19)

(11) Veröffentlichungsnummer: **0 005 163**
**A1**

# (12) EUROPÄISCHE PATENTANMELDUNG

(21) Anmeldenummer: **79100947.5**

(22) Anmeldetag: **29.03.79**

(51) Int. Cl.²: **H 01 L 21/263**, H 01 L 29/48, C 23 C 15/00

(30) Priorität: **26.04.78 US 900213**

(43) Veröffentlichungstag der Anmeldung: **14.11.79**
**Patentblatt 79/23**

(84) Benannte Vertragsstaaten: **DE FR GB**

(71) Anmelder: **International Business Machines Corporation, Armonk, N.Y. 10504 (US)**

(72) Erfinder: **Gniewek, John James, 12 Cady Lane, Wappingers Falls, NY 12590 (US)**
Erfinder: **Reith, Timothy Martin, 31 Claudie Drive, Poughkeepsie, NY 12603 (US)**
Erfinder: **Sullivan, Michael James, RD 1, Church Road, Redhook, NY 12571 (US)**
Erfinder: **White, James Francis, 17 Lake View Drive, Newburgh, NY 12550 (US)**

(74) Vertreter: **Böhmer, Hans Erich, Dipl.-Ing., Schönaicher Strasse 220, D-7030 Böblingen (DE)**

(54) **Verfahren zum Herstellen eines PtSi-Schottky-Sperrschichtkontakts.**

(57) Die Anmeldung behandelt ein Verfahren zum Herstellen eines PtSi-Schottky-Sperrschichtkontakts. Nach Herstellung eines Kontaktes aus Platinsilicid (5) in einer Öffnung (3) einer auf der Oberfläche eines Siliciumsubstrats (1) angebrachten Isolierschicht (2) für die Bildung einer Schottky-Sperrschichtdiode in einem Silicium-Halbleitersubstrat wird das noch verbleibende, nicht umgesetzte Platin (4) durch Zerstäubungsätzen in einer Edelgasatmosphäre in Verbindung mit Sauerstoff oder Stickstoff abgeätzt.

- 1 -

Verfahren zum Herstellen eines PtSi-Schottky-
Sperrschichtkontakts

Die Erfindung betrifft ein Verfahren zum Herstellen
einer Platinsilicid-Schottky-Sperrschichtdiode durch
selektives Ätzen von Platin in Anwesenheit von Platinsilicid, und insbesondere die Anwendung dieses Verfahrens bei der Herstellung von Platinsilicid-Kontakten
bei der Fertigung von Schottky-Sperrschichtdioden.
Durch das neue Verfahren soll erreicht werden, daß das
bei der Bildung des aus Platinsilicid gebildeten
Kontaktbereichs für die Schottky-Sperrschichtdiode
verbliebene, nicht umgesetzte Platin mit größerem
Wirkungsgrad abgeätzt werden kann, als das bisher möglich war. Dies soll insbesondere dadurch erreicht werden, daß man die durch Zerstäubungsätzen erzielbare
Ätzgeschwindigkeit von Platin gegenüber der durch Zerstäubungsätzen erreichbaren Ätzgeschwindigkeit von
Platinsilicid beträchtlich erhöht.

Die Erfindung ist also auf Schottky-Sperrschichtdioden
und insbesondere auf derartige Schottky-Sperrschichtdioden anwendbar, die sich leicht in integrierte Halbleiterschaltungen integrieren lassen.

Bauelemente mit Oberflächensperrschichten, die den
Schottky-Effekt ausnutzen, der auf die Gleichrichtereigenschaften einer Trennfläche zwischen einem Metall
und einem Halbleiter zurückzuführen ist, sind allgemein bekannt. Es ist ferner bekannt, daß Schottky-
Sperrschichtdioden nicht nur hohe Umschaltgeschwindigkeiten aufweisen, sondern auch einen relativ geringen
Durchlaßwiderstand und damit geringe Einschaltspannungen

FI 978 001

aufweisen. Daher ist der Wunsch nach Verwendung von Schottky-Sperrschichtbauelementen in integrierten monolithischen Schaltungen allgemein anerkannt. Die beiden am meisten erwünschten Anwendungen von Schottky-Sperrschichtdioden sind (1) Überbrückungsschutzschalter über P-N-Halbleiterübergänge und (2) für die Speicherung in aus Schottky-Sperrschichtdioden aufgebauten, als integrierte Schaltungen ausgeführten monolithischen Speicheranordnungen. Der wesentliche Vorteil der Schottky-Sperrschichtdiode gegenüber anderen Dioden liegt in ihrem relativ niedrigen Durchlaßwiderstand. Da die Schottky-Sperrschicht einen relativ geringen Durchlaßwiderstand aufweist, können Schottky-Sperrschichtdioden dazu verwendet werden, einen Transistor aus der Sättigung herauszuhalten, so daß man bei digitalen Schaltungen ein schnelleres Abschalten und damit höhere Umschaltgeschwindigkeiten erreicht. Derartige Dioden haben auch bei Einsatz in Speicheranordnungen einen kleineren Spannungsbedarf, so daß die Wärmeentwicklung und die Verlustleistung klein bleiben.

Eine in großem Maßstabe für die Herstellung von ohmschen Kontakten und Verbindungen in derzeit hergestellten integrierten Schaltungen benutzte Metallisierung stellt die Verwendung einer Schicht aus Platinsilicid in den Kontaktbohrungen für die Herstellung einer unmittelbar leitenden Verbindung zwischen dem Siliciumsubstrat und einer über dem Platinsilicid liegenden Aluminiumschicht dar. Diese Aluminiumschicht hat die gleiche Ausdehnung wie die aus einem Leitungsmuster bestehende, über der Isolier-schicht über dem Halbleitersubstrat liegende, die Ver-bindungsleitungen darstellende Aluminiumschicht. Der Grund für die Verwendung von Platinsilicid in den Kontaktbohrungen liegt darin, daß sich mit Aluminium

FI 978 001

bei der Kontaktierung von Silicium-Halbleitersubstraten nur wenig zufriedenstellende, unmittelbar ohmsche Verbindungen herstellen lassen.

Obgleich derartige zusammengesetzte Metallisierungen aus Aluminiumschichten über Platinsilicid in integrierten Schaltungen mit ohmschen Kontakten in großem Maße benutzt worden sind und selbst für eine Verwendung in Schaltungen, die sowohl ohmsche Kontakte als auch Schottky-Sperrschichtkontakte aufweisen (vergleiche US-Patentschrift 3 506 893), hat es bei der Herstellung doch Schwierigkeiten gegeben.

Allgemein wird in der Herstellung von Platinsilicid-Kontakten eine relativ dünne Schicht aus einem dielektrischen Material oder einer isolierenden Schicht in Form eines Leitungsmusters auf einem Silicium-Halbleitersubstrat vorgesehen, wobei Kontaktbohrungen in den Bereichen angeordnet sind, wo Schottky-Sperrschichtdioden hergestellt werden sollen. Über der gesamten Oberfläche wird dann durch übliche Niederschlagsverfahren, wie z. B. Niederschlag aus der Dampfphase oder vorzugsweise durch Kathodenzerstäubung eine dünne Schicht aus Platin niedergeschlagen. Bei einer Kurzzeit-Wärmebehandlung verbindet sich das Platin in den Kontaktbohrungen mit dem Silicium und bildet Platinsilicid. Die nicht umgesetzte Platinschicht wird dann entfernt, während die Platinsilicid-Schicht in den Kontaktbohrungen erhalten bleibt.

Obgleich das Zerstäubungsätzen von Platin bereits bekannt ist (vergleiche US-Patentschriften 3 271 286 und 3 975 252), ist die Entfernung von nicht umgesetztem Platin wegen der ähnlichen Ätzgeschwindigkeiten beim Zerstäubungsätzen für Platin (etwa 9,5 Nanometer/min)

FI 978 001

und Platinsilicid (etwa 8,0 Nanometer/min) normalerweise durch nasse Ätzverfahren mit Ätzmitteln, wie z. B. Königswasser durchgeführt worden (vergleiche US-Patentschriften 3 271 286, 3 855 612, 3 956 527, 3 968 272 und 3 995 301).

Die Nachteile derartiger Ätzmittel sind darin zu sehen, daß eine Verunreinigung durch die verschiedenen Ätzmittel möglich ist und daß sich die Ätzgeschwindigkeiten von Platin und Platinsilicid nur geringfügig unterscheiden. Außerdem müssen die so behandelten Schaltungen noch gespült und getrocknet werden.

Es wurde jedoch festgestellt, daß man einen wesentlich größeren Unterschied in der bei Zerstäubungsätzen erzielbaren Ätzgeschwindigkeit von Platin im Vergleich mit Platinsilicid dadurch erreichen kann, daß man das Zerstäubungsätzen in einer Atmosphäre eines Edelgases durchführt, welche mindestens 1 Volumprozent Sauerstoff oder Stickstoff, und vorzugsweise in einer aus Argon bestehenden Atmosphäre durchführt, die 10 Volumprozent Sauerstoff enthält.

Die Erfindung wird nunmehr anhand von Ausführungsbeispielen in Verbindung mit den beigefügten Zeichnungen im einzelnen näher erläutert.

In den Zeichnungen zeigt
Fig. 1A - 1F     schematisch Querschnittsansichten eines Teils einer integrierten Schaltung mit einer Schottky-Sperrschichtstruktur zur Darstellung der verschiedenen Verfahrensschritte bei der Herstellung,

FI 978 001

0005163

Fig. 2        ein Diagramm zur Darstellung der bei
              Zerstäubungsätzen erzielbaren Ätzge-
              schwindigkeit von verschiedenen Materia-
              lien in bezug auf den Sauerstoffgehalt
              in einer Argon-Atmosphäre, und

Fig. 3        ein Balkendiagramm zur Darstellung der
              mit einer Abtast-Mikrosonde ermittelten
              relativen Spitzenwerte des auf einem
              Substrat nach dem Ätzen verbleibenden
              Materials.

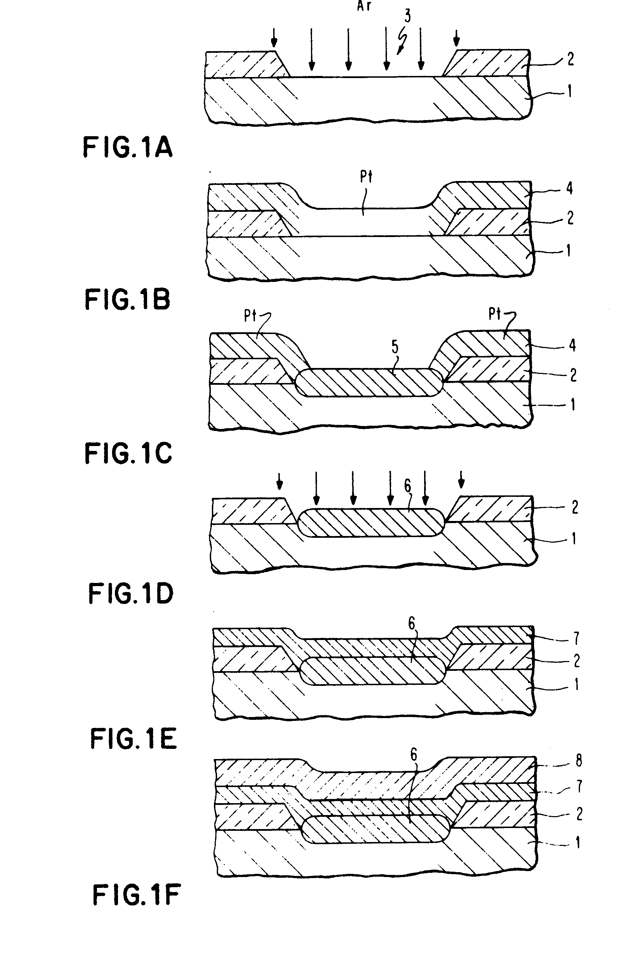

Fig. 1A zeigt in einer Querschnittsansicht einen Teil
einer integrierten Dünnfilmschaltung bei einer für die
Ausübung der Erfindung geeigneten Verarbeitungsstufe.
Auf einem gewöhnlich aus Silicium bestehenden Halbleitersubstrat mit einer relativ dünnen Schicht 2 aus einem
isolierenden Dielektrikum auf seiner Oberfläche ist eine
als Muster ausgebildete Siliciumdioxid-Schicht aufgebracht, die mit einer Bohrung 3 zur Aufnahme eines aus
Platinsilicid bestehenden Schottky-Sperrschichtkontakts
versehen ist. Obgleich die Isolierschicht 2 hier als
ein aus Siliciumdioxid bestehendes Dielektrikum angegeben ist, das eine Dicke von etwa 250 Nanometer aufweisen kann, so ist doch klar, daß diese Isolierschicht
auch aus einem anderen dielektrischen isolierenden
Schichtmaterial bestehen kann, wie es üblicherweise bei
integrierten Schaltungen verwendet wird, wie z. B.
Siliciumnitrid oder eine Siliciumnitrid enthaltende
Zusammensetzung. Die in Fig. 1A dargestellte Struktur
kann durch irgendeines der bekannten Verfahren zum Herstellen integrierter Schaltungen, wie z. B. durch das
in der US-Patentschrift 3 539 876 beschriebene Verfahren,
hergestellt sein.

Für die nachfolgenden Verfahrensschritte wird das

FI 973 001

0005163

Substrat in eine Beschickungsschleuse einer Zerstäubungsvorrichtung (z. B. Materials Research Corp., Modell 822) eingegeben, d.h. ein bei Hochfrequenz (13 MHz) arbeitendes Diodenzerstäubungssystem, das eine Beladungs- oder Beschickungsschleuse mit Quarzheizstäben und eine Beschichtungs- oder Zerstäubungskammer aufweist, die drei unterschiedliche Prallplatten und eine Auffangplatte für die Kathodenzerstäubung aufweist. Nach Auspumpen der Beschickungsschleuse auf etwa $1,333 \times 10^{-4}$ Millibar werden die Substrate in die Zerstäubungskammer überführt, wobei die Auffangplatte in einer für eine Reinigung durch Zerstäubungsätzen geeignete Position gebracht ist. Zum Sicherstellen einer sauberen Silicium-Oberfläche werden das Siliciumdioxid und die freiliegende Silicium-Oberfläche für 2-1/2 Minuten in einer Argon-Atmosphäre bei einem Druck von 5 Mikron durch Zerstäubungsätzen behandelt. (Dieser Verfahrensschritt kann dann weggelassen werden, wenn die Halbleiterscheiben vor Einbringen in das Zerstäubungssystem sauber genug sind).

Nach der Reinigung wird die Auffangplatte gedreht, so daß eine Platin-Aufprallplatte in Position gebracht wird. Daraufhin wird bei einer Leistung von 500 Watt in 2-1/2 Minuten durch Zerstäubung in einer 5 Mikron Atmosphäre aus Argon ein 60 Nanometer starker Film 4 aus Platin über der gesamten Oberfläche der Isolierschicht 2 und in der Kontaktbohrung 3 niedergeschlagen. Die mit Platin überzogene Halbleiterscheibe wird dann in die Beschickungsschleuse überführt und dort bei einem Druck von $1,33 \times 10^{-4}$ Millibar bei einer Temperatur von $550^{\circ}$C für 20 Minuten gesintert. Dieser Sintervorgang hat zur Folge, daß sich in der Kontaktbohrung 3 aus der Kombination von Platin mit dem freiliegenden Silicium des Substrats 1 eine Platinsilicid-Zone 5 bildet, während die

FI 978 001

übrige Platinschicht 4 unbeeinflußt bleibt, d. h. sich nicht mit Silicium oder mit der Isolierschicht 2 verbindet.

Die gesinterten Substrate werden dann erneut von der Beschickungsschleuse in die Zerstäubungskammer eingebracht, und die Auffangplatte wird für eine Zerstäubungsätzung des nicht umgesetzten Platins auf dem Substrat gedreht. In der bevorzugten Ausführungsform wird das nicht umgesetzte Platin für eine Dauer von 12 Minuten bei einer Leistung von 100 Watt in einer 5 Mikron Atmosphäre von Argon geätzt, die 10 Volumprozent Sauerstoff enthält. Es ist dabei darauf hinzuweisen, daß zwar Argon als die bei der Zerstäubungsätzung benutzte Atmosphäre genannt wurde, daß jedoch jedes Gas verwendet werden kann, das gegenüber Platin chemisch völlig inaktiv ist, wie z. B. andere Edelgase, wie Helium, Neon, Krypton, Xenon und Radon.

Der eigentliche erfinderische Schritt besteht darin, das nicht umgesetzte Platin auf die angegebene Weise zu entfernen, während der Platinsilicid-Kontakt 6 in den Kontaktbohrungen erhalten bleibt. Da die Reaktion von Platin mit Silicium eine Platinsilicid-Schicht liefert, die etwa doppelt so dick ist wie die ursprüngliche Platinschicht, ergibt eine Zerstäubungsätzung in reinem Argon (in dem Platin und Platinsilicid etwa mit der gleichen Ätzgeschwindigkeit abgeätzt werden, nämlich etwa 9,5 Nanometer je Minute bzw. 8,5 Nanometer je Minute), nach Abschluß des Ätzverfahrens eine Platinsilicid-Schicht, die angenähert so dick ist wie die ursprüngliche Platinschicht. Beispielsweise liefert eine Platinschicht einer Schichtdicke von 50 Nanometern eine Platinsilicid-Schicht mit einer Dicke von etwa 100 Nanometern, und das Abätzen von 50 Nanometern nicht

FI 978 001

umgesetzten Platins entfernt außerdem auch 50 Nanometer Platinsilicid, so daß in den Kontaktbohrungen eine Schichtdicke von 50 Nanometern Platinsilicid verbleibt. Obwohl durch dieses Verfahren brauchbare Kontakte hergestellt werden können, ist es trotzdem erwünscht, so wenig wie möglich von dem Platinsilicid abzuätzen.

Es wurde festgestellt, daß die Beigabe von Sauerstoff zu einem Edelgas (z. B. Argon) in der Atmosphäre bei der Zerstäubungsätzung die Ätzgeschwindigkeit für Platinsilicid bezüglich der Ätzgeschwindigkeit von Platin herabsetzt.

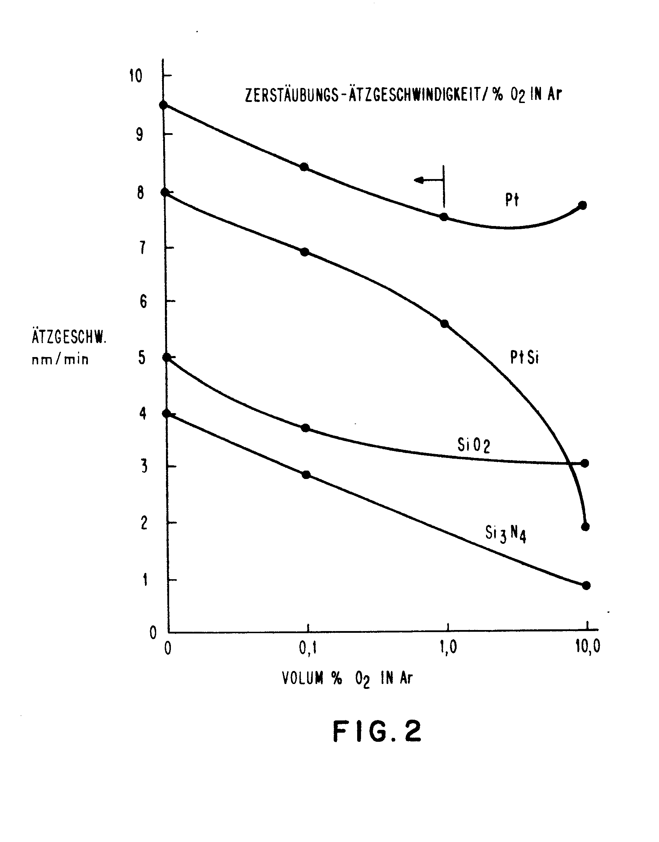

Die Bestimmung von Ätzgeschwindigkeiten bei Zerstäubungsätzen wurde mit reinen Schichten aus Platin, Platinsilicid, Siliciumdioxid ($SiO_2$) und Siliciumnitrid ($Si_3N_4$) als Funktion des Sauerstoffanteils in der Argon-Atmosphäre durchgeführt. Die Ätzgeschwindigkeiten wurden durch Zerstäubungsätzen von maskierten Proben über verschieden lange Zeiten und durch Messen des abgetragenen Materials mit einem Meßgerät vom Typ Taylor Hobson Talystep 1 ermittelt. Fig. 2 zeigt die Ergebnisse von zwei verschiedenen Gruppen von Versuchen. Fig. 2 zeigt dabei, daß die Beigabe von Sauerstoff die Ätzgeschwindigkeiten von $SiO_2$, $Si_3N_4$ und Pt nur mäßig verringert, während die Ätzgeschwindigkeit von PtSi auf etwa 1/4 der Ätzgeschwindigkeit von Pt in Ar + 10% $O_2$ stark verringert wird. Man sieht, daß der Unterschied in den Ätzgeschwindigkeiten von Pt und PtSi zuzunehmen beginnt, wenn die Argon-Atmosphäre etwa 1 Volumprozent $O_2$ enthält.

Wie aus Fig. 2 zu erkennen, läßt sich PtSi etwa mit der gleichen Ätzgeschwindigkeit ätzen wie $SiO_2$, wenn die Argon-Atmosphäre etwa 10 Volumprozent Sauerstoff enthält.

0005163

Es wird angenommen, daß dies deshalb der Fall ist, weil die Anwesenheit von 10 Volumprozent Sauerstoff in Argon zur Folge hat, daß beim reaktiven Zerstäubungsätzen sich $SiO_2$ auf der Oberfläche von PtSi bildet und dann durch Zerstäubung abgetragen wird. Dieses $SiO_2$ bildet sich offensichtlich nicht auf der Oberfläche von Pt, da im Platin kein Siliciumvorhanden ist. Demgemäß wird angenommen, daß Stickstoff, der sich beim reaktiven Zerstäubungsätzen ebenfalls mit Silicium verbinden kann, während des Zerstäubungsätzens von nicht umgesetztem Platin in der Argon-Atmosphäre eingesetzt werden kann. In gleicher Weise wird sich bei Verwendung von Stickstoff auf der Platinsilicid-Oberfläche durch reaktive Zerstäubung Siliciumnitrid bilden und dies kann anschließend durch Zerstäubungsätzen entfernt werden.

Wenn mindestens 1 Volumprozent Sauerstoff in der Argon-Atmosphäre vorhanden ist, ist am Ende des Ätzvorgangs die Dicke der PtSi-Schicht größer. Bei dem vorher genannten Beispiel (wobei 50 Nanometer Pt etwa 100 Nanometer PtSi ergeben) wird durch Abätzen von 50 Nanometern nicht umgesetzten Platins in einer Argon-Atmosphäre, die 10 Volumprozent Sauerstoff enthält, eine Schicht mit einer Dicke von etwa 12,5 Nanometer PtSi abgetragen, so daß in den Kontaktbohrungen PtSi mit einer Schichtdicke von 87,5 Nanometer verbleibt.

Das Auftreten von Verunreinigungen auf den Substraten wurde ebenso untersucht, wie auch die Auswirkungen einer Überätzung auf die endgültige Schichtdicke des PtSi in den Kontaktbohrungen. Zu diesem Zweck wurden 5 Halbleiterscheiben mit offenen Kontaktbohrungen gereinigt, daraufhin wurde Platin mit einer Schichtdicke von 60 Nanometern durch Zerstäubung niedergeschlagen, worauf dann die Halbleiterscheiben in der Beschickungsschleuse zur

FI 978 001

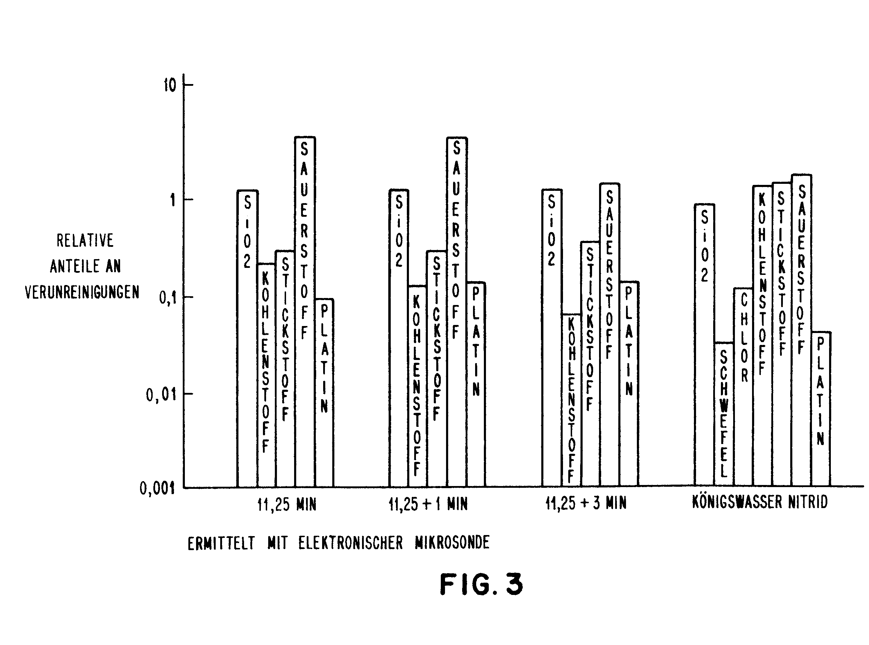

Bildung von PtSi im Vakuum gesintert wurden. Eine Halbleiterscheibe wurde zur Kontrolle beiseite gelegt und eine andere Halbleiterscheibe wurde für 20 Minuten in frisch angesetztem Königswasser geätzt und anschließend mit Wasser abgespült. Die übrigen drei Halbleiterscheiben wurden in das Zerstäubungssystem eingegeben und in einer Atmosphäre aus Argon und 10% Sauerstoff zum Abtragen von nicht umgesetztem Platin (z. B. für 11,25 Minuten) behandelt. Eine Halbleiterscheibe wurde aus dem System entnommen und die zwei anderen Halbleiterscheiben wurden für eine weitere Minute durch Zerstäubungsätzen behandelt. Dann wurde eine weitere Halbleiterscheibe entnommen, und die letzte Halbleiterscheibe wurde für zwei weitere Minuten durch Zerstäubungsätzen geätzt. Alle vier geätzten Halbleiterscheiben wurden zur Bestimmung von Platin an der Oberfläche und der Anwesenheit anderer Verunreinigungen untersucht. Ebenso wurde die Schichtdicke von PtSi unter Verwendung einer Elektronen-Mikrosonde der Firma Applied Research Lab. bestimmt. Die Ergebnisse dieser Untersuchung sind in Fig. 3 zusammengefaßt, und man sieht, daß nach 11,25 Minuten wenig mehr Pt (angenähert $10^{15}$ Atome je $cm^2$) auf der Sub-stratoberfläche der in Ar + 10% $O_2$ geätzten Probe verblieb, verglichen mit der in Königswasser geätzten Halbleiter-scheibe (angenähert $4 \times 10^{14}$ Atome je $cm^2$). Die in Königs-wasser geätzte Halbleiterscheibe enthielt jedoch merkliche Anteile einer Verunreinigung durch Chlor und Schwefel, die bei der durch Zerstäubungsätzung behandelten Halbleiterscheibe nicht beobachtet worden war. Außerdem waren die Anteile an Kohlenstoff und Stickstoff in den mit Königswasser geätzten Halbleiterscheiben größer als bei den durch Zerstäubungsätzen behandelten Halbleiterscheiben.

Überätzen, d. h. Zerstäubungsätzen für um eine und drei weitere Minuten in Ar + 10% $O_2$ hatte nur geringfügige

FI 978 001

Wirkung, ausgenommen einer leichten Erhöhung bei Platin, das wahrscheinlich auf eine Rückstreuung von der Substrathalterung und den Seitenwänden der Reaktionskammer zurückzuführen war. Die Schichtdicke von PtSi in den Kontaktbohrungen nach der Ätzung zeigt nachfolgende Aufstellung:

1. unbehandelt (keine Ätzung)          110 Nanometer
2. Königswasser                        110 Nanometer
3. Ar + 10% $O_2$, 11,25 Minuten       103 Nanometer
4. Ar + 10% $O_2$, 12,25 Minuten        97 Nanometer
5. Ar + 10% $O_2$, 14,25 Minuten        97 Nanometer

Diese Daten zeigen deutlich, daß eine Zerstäubungsätzung von Platin in einer Atmosphäre aus Argon mit 10 Volumprozent Sauerstoff eine geringfügige Verdünnung der PtSi-Schicht im Vergleich zum Ätzen mit Königswasser liefert und daß eine Überätzung (z. B. Zerstäubung) eine weitere Verdünnung der PtSi-Schicht liefert, die jedoch sehr gering ist.

Im allgemeinen kann festgestellt werden, daß was restliches Pt, Verunreinigung und die schließlich erreichte Schichtdicke der PtSi-Schicht betrifft, die Ar + $O_2$-Zerstäubungsätzung ein besseres Ergebnis liefert als die Ätzung durch Königswasser.

Nach der Zerstäubungsätzung des nicht umgesetzten Platins läßt sich die Schottky-Sperrschichtdiode weiter fertig herstellen, wie dies beispielsweise in den US-Patentschriften 3 906 540 oder 3 995 301 beschrieben ist.

Andererseits kann die Auffangplatte des Zerstäubungssystems zur Ausrichtung einer mit Titan-Wolfram-Legierung überzogenen Prallplatte mit dem Substrat gedreht

FI 978 001

werden, und damit kann durch Zerstäubung ein 100 Nanometer starker Film aus einer Legierung aus 10 Gewichtsprozent Ti und 90 Gewichtsprozent W über eine Dauer von 10 Minuten in einer Atmosphäre von 5 Mikron Ar bei 500 Watt niedergeschlagen werden. Diese TiW-Schicht 7 wird als Diffusionssperrschicht benutzt und verhindert, daß ein anschließend niedergeschlagener Film aus Aluminium mit dem Platinsilicid reagiert. Die überschüssigen Teile der aus Ti und W bestehenden Schicht 7 können dann auf geeignete Weise entfernt werden, vorzugsweise durch Zerstäubungsätzen mit einer geeigneten Maske.

Schließlich wird zur Herstellung von Leitungsverbindungen eine aus Aluminium-Kupfer bestehende Schicht 8 mit einer Dicke von 850 Nanometern aus einer vierten Prallplatte des Zerstäubungssystems über eine Dauer von 30 bis 60 Minuten in einer Atmosphäre von 5 Mikron Argon bei 500 Watt niedergeschlagen, wobei die Festlegung des Verbindungsleitungsmusters durch reaktives Ionenätzen durchgeführt wird. Andererseits können für sogenannte Abzugsverfahren, wo ein normaler Niederschlag erforderlich ist, die mit TiW überzogenen Halbleiterscheiben aus dem Zerstäubungssystem herausgenommen werden. Die AlCu-Schicht 8, die im Vergleich mit der nur 100 Nanometer starken TiW-Schicht 7 dick ist und das im Kontaktbereich 6 liegende PtSi würden durch Verdampfung niedergeschlagen, worauf dann üblicherweise das Leitungsmuster hergestellt würde.

FI 978 001

- 1 -

PATENTANSPRÜCHE

1. Verfahren zum Zerstäubungsätzen von Platin bei Anwesenheit von Platinsilicid, dadurch gekennzeichnet, daß beim Ätzen in einer Edelgasatmosphäre der Unterschied zwischen den Ätzgeschwindigkeiten von Platin und Platinsilicid dadurch erhöht wird, daß die Edelgasatmosphäre mindestens 1 Volumprozent an Sauerstoff oder Stickstoff enthält.

2. Verfahren nach Anspruch 1 zum Herstellen von Schottky-Sperrschichtkontakten auf einem eine Anzahl von aktiven Bauelementen enthaltenden, mit einer Isolierschicht überzogenen Siliciumsubstrat mit mindestens einer Kontaktbohrung in der Isolierschicht und einer über der Isolierschicht und der Kontaktbohrung angebrachten Platinschicht, die durch gemeinsames Sintern mit dem Siliciumsubstrat innerhalb der Kontaktbohrung in Platinsilicid umgewandelt wird, dadurch gekennzeichnet, daß das nicht umgesetzte Platin in einer Edelgasatmosphäre, die mindestens 1 Volumprozent Sauerstoff oder Stickstoff enthält, durch Zerstäubungsätzen abgetragen wird.

3. Verfahren nach Anspruch 1 oder 2, dadurch gekennzeichnet, daß eine Argon-Atmosphäre verwendet wird, die 1o Volumprozent Sauerstoff enthält.

FI 978 001

1/3

Ar
3

2

1

**FIG.1A**

Pt

4
2
1

**FIG.1B**

Pt                    Pt

5
4
2
1

**FIG.1C**

6

2
1

**FIG.1D**

6

7
2
1

**FIG.1E**

6

8
7
2
1

**FIG.1F**

FIG. 2

FIG. 3

0005163

**Europäisches Patentamt**

# EUROPÄISCHER RECHERCHENBERICHT

Nummer der Anmeldung

EP 79 100 947.5

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | US – A – 3 927 225 (GENERAL ELECTRIC COMP.)<br>* Ansprüche 1, 5, 7 und 9, Spalte 3, Zeile 56 bis Spalte 4, Zeile 24 *<br><br>-- | 1,2 |
| A | US – A – 3 900 344 (IBM CORP.)<br>* Anspruch 1, Spalte 4, Zeilen 1 bis 15 *<br><br>-- | 1,2 |
| D,A | US – A – 3 271 286 (BELL TELEPHONE LABORATORIES)<br>* gesamtes Dokument *<br><br>---- | |

### KLASSIFIKATION DER ANMELDUNG (Int.Cl.²)

H 01 L   21/263
H 01 L   29/48
C 23 C   15/00

### RECHERCHIERTE SACHGEBIETE (Int. Cl.²)

C 23 C   15/00
H 01 L   21/263
H 01 L   29/48

### KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie. übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 27-07-1979 | ROTHER |

EPA form 1503.1   06.78